# EUROPEAN PATENT APPLICATION

(11) **EP 4 651 649 A1**
(43) Date of publication of application: **19.11.2025**
(21) Application number: 24806162.4
(22) Date of filing: 12.03.2024
(51) Int. Cl.: H05K 5/02

(54) **VAPOR CHAMBER AND ELECTRONIC DEVICE**

(30) Priority: 12.05.2023 CN 202310541011
(71) Applicant: Honor Device Co., Ltd., Shenzhen, Guangdong 518040 (CN)
(72) Inventor: FU, Guochao, Shenzhen, Guangdong 518040 (CN); WANG, Shushu, Shenzhen, Guangdong 518040 (CN); YANG, Yuanru, Shenzhen, Guangdong 518040 (CN)
(74) Representative: Gill Jennings & Every LLP
(86) International application number: PCT/CN2024/081184
(87) International publication number: WO 2024/234802

(57) **Abstract**

Embodiments of this application relate to the field of electronic device technologies, and provide a vapor chamber and an electronic device. The vapor chamber includes: a housing, where the housing includes a first cover plate and a second cover plate, the first cover plate is connected to the second cover plate to enclose a closed cavity, and the cavity is provided with a cooling medium; a capillarity structure, disposed in the cavity; and a heat dissipation structure, disposed in an inner surface of the cavity, where the heat dissipation structure includes at least one structure of a protrusion and a groove. The vapor chamber and electronic device provided in embodiments of this application have good heat dissipation performance.

## Description

This application claims priority to Chinese Patent Application No. 202310541011.X, filed with the China National Intellectual Property Administration on May 12, 2023 and entitled "VAPOR CHAMBER AND ELECTRONIC DEVICE", which is incorporated herein by reference in its entirety.

### TECHNICAL FIELD

This application relates to the field of electronic device technologies, and in particular, to a vapor chamber and an electronic device.

### BACKGROUND

As a high-efficiency phase-change heat transfer element, a vapor chamber has been widely used in various terminal electronic products such as a mobile phone and a computer. As a performance requirement for an electronic product increases, power consumption of the entire electronic product also increases, and a performance requirement of the vapor chamber also increases. Therefore, heat dissipation performance of an existing vapor chamber is to be improved.

### SUMMARY

Embodiments of this application provide a vapor chamber and an electronic device for improving heat dissipation performance of the vapor chamber.

To achieve the foregoing objective, the following technical solutions are used in embodiments of this application.

According to a first aspect, an embodiment of this application provides a vapor chamber, including:
a housing, where the housing includes a first cover plate and a second cover plate, the first cover plate is connected to the second cover plate to enclose a closed cavity, and the cavity is provided with a cooling medium;
a capillarity structure, disposed in the cavity; and
a heat dissipation structure, disposed in an inner surface of the cavity, where the heat dissipation structure includes at least one structure of a protrusion and a groove.

The foregoing technical solutions in embodiments of this application at least have the following technical effects or advantages.

The vapor chamber provided in this embodiment of this application includes the housing having the cavity, and the capillarity structure and the heat dissipation structure that are disposed in the cavity. The heat dissipation structure includes at least one structure of the protrusion and the groove, to increase a surface area in the cavity, in other words, improve a heat exchange surface area, thereby improving the heat dissipation performance of the entire vapor chamber. The heat dissipation structure is disposed in an interior of the cavity, so that space of the cavity can be used without increasing a thickness of the vapor chamber. Therefore, the heat dissipation performance of the vapor chamber can be improved when the vapor chamber meets an ultra-thin requirement for an electronic device.

In some embodiments, the vapor chamber includes an evaporation section and a condensation section, the evaporation section is a part of the vapor chamber corresponding to a heating component, and the condensation section is a part of the vapor chamber other than the evaporation section; and the heat dissipation structure is disposed in the evaporation section and/or the condensation section. In this embodiment of this application, based on a location of a heat source, the vapor chamber is divided into the evaporation section and the condensation section, and the heat dissipation structure may be disposed in the evaporation section and/or the condensation section, to improve overall performance of the vapor chamber.

In some embodiments, the second cover plate is closer to the heating component than the first cover plate, and the inner surface of the cavity includes a first surface of the first cover plate facing toward the cavity and a second surface of the second cover plate facing toward the cavity; and the heat dissipation structure is disposed on at least one of the first surface and the second surface. The heat dissipation structure may be disposed on the first surface and/or the second surface, so that a heat exchange surface area of the vapor chamber can be increased, and a manufacturing process is simple.

In some embodiments, the heat dissipation structure is disposed on the second surface and at least disposed in the evaporation section. The heat dissipation structure is disposed on the second surface and located in the evaporation section, so that a heat dissipation surface area of the evaporation section can be improved, thereby improving heat exchange efficiency between the heating component and the vapor chamber, and improving heat dissipation efficiency.

In some embodiments, the capillarity structure is at least attached to the second surface.

In some embodiments, the heat dissipation structure includes the groove, and the groove can accommodate a part of the cooling medium. The foregoing technical solutions are used, so that the groove can accommodate the part of the cooling medium, and the groove increases a water accumulation capability, to play a role of double capillarity.

In some embodiments, the groove extends from the evaporation section to the condensation section, and the groove is for allowing the cooling medium to flow from the condensation section to the evaporation section. The foregoing technical solutions are used, so that the groove may be used as a flow channel for the cooling medium to flow from the condensation section to the evaporation section. The groove is provided on the second surface, does not occupy vapor return space in the cavity, and does not affect return of vapor while increasing capillarity force.

In some embodiments, a depth of the groove is 40% to 60% of a thickness of the second cover plate. By setting the depth of the groove to satisfy the foregoing condition, not only the surface area of the cavity can be effectively increased, but also impact on structural stability of the second cover plate caused by the groove being excessively deep can be avoided.

In some embodiments, a depth of the groove ranges from 10 micrometers to 1000 micrometers. The depth of the groove may be controlled based on the thickness of the vapor chamber and a manufacturing process.

In some embodiments, the capillarity structure covers the heat dissipation structure, and there is a gap between a bottom of the groove and the capillarity structure. In this way, the groove can independently accommodate the cooling medium and allow the cooling medium to flow, and play a role of double capillarity.

In some embodiments, the housing includes a first part and a second part, the second part is in bent connection with the first part, the evaporation section is disposed at the second part, and the condensation section is disposed at the first part; and the groove extends from the evaporation section to the first part, and the groove extends in a straight line or an arc. A shape of the groove can be adapted to an arrangement manner of the evaporation section and the condensation section, so that the cooling medium flows in the groove to return to the evaporation section.

In some embodiments, the vapor chamber is provided with a plurality of evaporation sections, and one or more of the plurality of evaporation sections is provided with the heat dissipation structure. One or more of the plurality of evaporation sections is provided with the heat dissipation structure, so that each heat dissipation structure may be used to separately dissipate heat from a corresponding heating component.

In some embodiments, the heat dissipation structure is disposed on the second surface and the heat dissipation structure is located in the condensation section.

In some embodiments, the heat dissipation structure is disposed on the first surface and the heat dissipation structure is located in the condensation section.

The foregoing technical solutions are used, so that the heat dissipation structure can improve a heat exchange surface area of the condensation section, thereby improving the overall performance of the vapor chamber.

In some embodiments, the vapor chamber further includes a support structure, and the support structure extends from the inner surface of the cavity to an interior of the cavity. The support structure can maintain space in the cavity, so that the vapor can flow in the cavity. The support structure is disposed between the first cover plate and the second cover plate, and can further improve a deformation resistance capability of the entire vapor chamber.

In some embodiments, the support structure includes a plurality of columns or bumps arranged in an array. The support structure forms a vapor channel in the cavity, to allow the vapor to flow in the cavity.

In some embodiments, the support structure and the heat dissipation structure are both disposed on the first surface, and a height of the heat dissipation structure on the first surface is less than or equal to a height of the support structure.

In some embodiments, the heat dissipation structure, the support structure, and the first cover plate are of an integrated structure. The heat dissipation structure and the support structure can be simultaneously manufactured on the first cover plate, so that high manufacturing efficiency and low costs are achieved for the vapor chamber.

In some embodiments, the heat dissipation structure includes the protrusion, and the protrusion is a convex column or a convex prim.

In some embodiments, the heat dissipation structure includes a plurality of grooves, and sizes of the plurality of grooves are the same or sizes of at least two grooves are different; and/or

the heat dissipation structure includes a plurality of protrusions, and sizes of the plurality of protrusions are the same or sizes of at least two protrusions are different.

In some embodiments, the plurality of grooves are arranged at equal intervals; and/or the plurality of protrusions are arranged at equal intervals.

In some embodiments, the plurality of grooves are arranged parallel to each other; and/or the plurality of protrusions are arranged parallel to each other.

In some embodiments, a shape of a cross section of the protrusion or the groove includes at least one of a semi-circle, a circle, an ellipse, a triangle, a rectangle, a trapezoid, a pentagon, and a hexagon. A shape of the heat dissipation structure may be selected based on an actual use requirement, and a manufacturing manner is flexible and convenient.

In some embodiments, the heat dissipation structure includes a strip-shaped first heat dissipation part and a plurality of second heat dissipation parts connected to the first heat dissipation part, the plurality of second heat dissipation parts are sequentially arranged on two sides of the first heat dissipation part along an extension direction of the first heat dissipation part, and the first heat dissipation part and the second heat dissipation part are the protrusions or the grooves. The heat dissipation structure is in a shape of a leaf vein as a whole, not only increasing a heat dissipation surface area of the cavity, but also further increasing capillarity force.

In some embodiments, the second heat dissipation parts are obliquely connected to the first heat dissipation part. The second heat dissipation parts extend along both a length direction and a width direction of the vapor chamber, to improve the heat dissipation area and a heat dissipation effect

In some embodiments, the capillarity structure is a cellular medium made of a metal material.

In some embodiments, the capillarity structure is one or more of copper mesh, copper fiber, copper powder, or foam copper.

According to a second aspect, an embodiment of this application provides an electronic device, including the vapor chamber provided in the first aspect.

In some embodiments, the electronic device further includes a circuit board, a middle frame, and a display screen, the middle frame is provided with a mounting hole, the vapor chamber is at least partially embedded in the mounting hole, and the vapor chamber and the middle frame both carry the display screen; and the circuit board is disposed on a side of the middle frame facing away from the display screen and a heating component is disposed on the circuit board.

In some embodiments, the electronic device further includes a heat dissipation film, and the heat dissipation film is disposed on a side of the vapor chamber facing away from the circuit board, and/or a side of the circuit board facing away from the vapor chamber. The heat dissipation film is disposed, so that the electronic device uses both the vapor chamber and the heat dissipation film to dissipate heat of the heating component, thereby further improving a heat dissipation effect and performance stability.

The electronic device provided in this embodiment of this application includes the vapor chamber in the first aspect and has all the beneficial effects in the first aspect.

### BRIEF DESCRIPTION OF DRAWINGS

FIG. 1 is a schematic diagram of a structure of a vapor chamber according to an embodiment of this application;
FIG. 2 is a top view of a second cover plate in a vapor chamber according to an embodiment of this application;
FIG. 3 is a top view of a second cover plate in another vapor chamber according to an embodiment of this application;
FIG. 4 is a schematic diagram of a structure of another vapor chamber according to an embodiment of this application;
FIG. 5 is a top view of another vapor chamber according to an embodiment of this application;
FIG. 6 is a schematic diagram of a structure of another vapor chamber according to an embodiment of this application;
FIG. 7 is a schematic diagram of a structure of another vapor chamber according to an embodiment of this application;
FIG. 8 is a top view of a second cover plate in a vapor chamber according to an embodiment of this application;
FIG. 9 is a top view of another second cover plate according to an embodiment of this application;
FIG. 10 is a top view of another second cover plate according to an embodiment of this application;
FIG. 11 is a top view of another second cover plate according to an embodiment of this application;
FIG. 12 is a top view of another second cover plate according to an embodiment of this application;
FIG. 13 is a top view of another second cover plate according to an embodiment of this application;
FIG. 14 is a schematic diagram of a structure of another vapor chamber according to an embodiment of this application;
FIG. 15 is a schematic diagram of a structure of another vapor chamber according to an embodiment of this application;
FIG. 16 is a schematic diagram of a structure of another vapor chamber according to an embodiment of this application;
FIG. 17 is a schematic diagram of a structure of another vapor chamber according to an embodiment of this application; and
FIG. 18 is an exploded view of an electronic device according to an embodiment of this application.

Reference numerals in the accompanying drawings:
1000: Electronic device;
100: Vapor chamber; 101: Evaporation section; 102: Condensation section;
10: Housing; 10a: First part; 10b: Second part;
11: First cover plate; 111: First surface;
12: Second cover plate; 121: Second surface;
13: Cavity;
20: Capillarity structure;
30: Heat dissipation structure; 31: Groove; 32: Protrusion; 331: First heat dissipation part; 332: Second heat dissipation part;
40: Support structure; 41: Column;
50: Solder;
210: Heating component; 220: Display screen; 230: Middle frame; 231: Mounting hole; 240: Circuit board; 250: Heat dissipation film; 260: Rear housing; 270: Battery.

### DESCRIPTION OF EMBODIMENTS

Embodiments of this application are described in detail below, and examples of embodiments are shown in accompanying drawings, where same or similar elements or elements having same or similar functions are denoted by same or similar reference numerals throughout the description. Embodiments described below with reference to the accompanying drawings are examples, and are intended to explain this application and cannot be construed as a limitation to this application.

In the descriptions of this application, it should be understood that orientation or position relationships indicated by the terms, such as "length", "width", "thickness", "top", "bottom", "inner", "outer", "up", "down", "left", and "right", are based on orientation or position relationships shown in the accompanying drawings, and are used only for ease and brevity of illustration and description, rather than indicating or implying that the mentioned apparatus or element needs to have a particular orientation or needs to be constructed and operated in a particular orientation. Therefore, such terms should not be construed as limiting of this application.

The terms such as "first" and "second" are merely intended for description, and shall not be understood as an indication or implication of relative importance or implicit indication of the quantity of indicated technical features. In addition, the terms such as "first" and "second" do not indicate that the indicated features are necessarily different.

In this application, unless otherwise explicitly specified or defined, the terms such as "connect" and "connection" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two components, or an interaction relationship between two components. A person of ordinary skill in the art may understand the specific meanings of the foregoing terms in this application based on specific situations.

In this application, "and/or" only describes an association relationship between associated objects and represents that three relationships may exist. For example, A and/or B may represent the following three cases: Only A exists, both A and B exist, and only B exists. In addition, the character "/" in this specification generally indicates an "or" relationship between the associated objects.

It should be noted that, in this application, the terms such as "in an embodiment", an "example", or "for example" is used to represent giving an example, an illustration, or a description. Any embodiment or design scheme described as "in an embodiment", an " example", or "for example" in this application should not be explained as being more preferable or having more advantages than another embodiment or design scheme. Exactly, use of the terms such as "in an embodiment", an "example", or "for example" is intended to present a related concept in a specific manner.

To make the objectives, technical solutions, and advantages of this application clearer, the following further describes this application in detail with reference to the accompanying drawings and embodiments.

The vapor chamber is usually also referred to as a temperature equalizing plate, a super thermal conduction plate, or a thermal conduction plate. A vapor chamber (vapor chamber, VC) and a heat pipe operate on similar principles, and both achieve efficient heat exchange by utilizing latent heat of phase transition, heat conduction, and convection. Specifically, a cooling medium in a sealed cavity boils and turns from liquid into gas, which absorbs heat and then condenses back into liquid; and a gas-liquid phase transition cycle in hot and cold regions of the VC is completed with capillary action, gravity, and the like as cooling medium transport forces. The vapor chamber may be considered as a heat pipe having a higher shape degree of freedom, and may allow for an irregular design. A conventional heat pipe is used in only one-dimensional heat dissipation, and the vapor chamber may further implement two-dimensional and three-dimensional heat dissipation.

As a high-efficiency phase-change heat transfer element, the vapor chamber has been widely used in various terminal electronic products such as a mobile phone and a computer. As a performance requirement for an electronic product increases, power consumption of the entire electronic product also increases, and a performance requirement of the vapor chamber also increases. Restricted by a requirement of an ultra-thin architecture in a terminal electronic product, there is a conflict between an ultra-thin design and a high-performance requirement of the vapor chamber. In view of this, an embodiment of this application provides a vapor chamber. The vapor chamber includes a housing, a capillarity structure, and a heat dissipation structure. The housing is provided with a cavity. The heat dissipation structure is disposed in an inner surface of the cavity and the heat dissipation structure includes at least one structure of a groove or a protrusion. In this way, the heat dissipation structure is disposed in an interior of the vapor chamber, so that a surface area of the inner surface of the cavity is increased, to rapidly reduce temperature of a heating component, thereby effectively improving performance of the vapor chamber.

The vapor chamber provided in the technical solution of this application is used in an electronic device such as a mobile phone, a tablet computer, a notebook computer, and a related module, structural member, or functional member having a heat dissipation function. The electronic device having the vapor chamber provided in this application has good heat dissipation performance and stability.

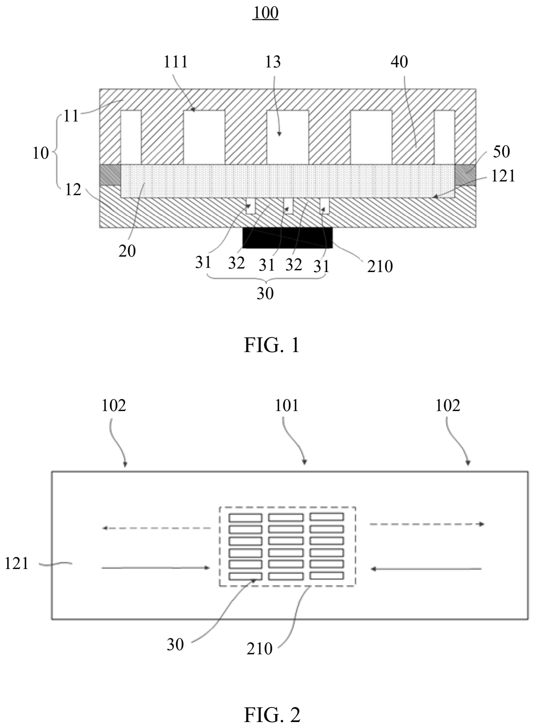

Refer to FIG. 1. An embodiment of a first aspect of this application provides a vapor chamber 100, configured to be in contact with a heat source to dissipate heat from the heat source. The vapor chamber 100 includes a housing 10, a capillarity structure 20, and a heat dissipation structure 30. The housing 10 includes a first cover plate 11 and a second cover plate 12, the first cover plate 11 is connected to the second cover plate 12 to enclose a closed cavity 13, and the cavity 13 is provided with a cooling medium; the capillarity structure 20 is disposed in the cavity 13; and the heat dissipation structure 30 is disposed in an inner surface of the cavity 13, where the heat dissipation structure 30 includes at least one structure of a protrusion 32 and a groove 31.

The housing 10 is a main body of the vapor chamber 100. A material of the first cover plate 11 and the second cover plate 12 may be, but is not limited to, copper. Alternatively, the material of the first cover plate 11 and the second cover plate 12 may be copper alloy, stainless steel, titanium or titanium alloy, tungsten or tungsten alloy, chromium or chromium alloy, and the like. The first cover plate 11 and the second cover plate 12 may be connected through high-temperature brazing. It may be understood that a connection manner between the first cover plate 11 and the second cover plate 12 is not limited thereto. After the first cover plate 11 is connected to the second cover plate 12, the closed cavity 13 is formed. The cavity 13 is configured to accommodate the capillarity structure 20, the cooling medium, and the heat dissipation structure 30. The closed cavity 13 can prevent the cooling medium from being lost. The cooling medium may be water, but is not limited thereto.

The capillarity structure 20 is for forming capillarity force to transport the cooling medium, to complete an entire power cycle and then complete a thermodynamic cycle, and is a key for maintaining two-phase heat exchange.

The heat dissipation structure 30 is disposed in the inner surface of the cavity 13. The cavity 13 is defined by the first cover plate 11 and the second cover plate 12, and a surface of the first cover plate 11 facing toward the cavity 13 and a surface of the second cover plate 12 facing toward the cavity 13 are both inner surfaces of the cavity 13. The heat dissipation structure 30 includes at least one structure of the protrusion 32 and the groove 31. To be specific, the heat dissipation structure 30 may include the protrusion 32, or may include the groove 31, or may include both the protrusion 32 and the groove 31. There may be one or more heat dissipation structures 30, and a quantity of protrusions 32 or grooves 31 included in each heat dissipation structure 30 is not limited in this application. As shown in FIG. 1, in some embodiments, the grooves 31 and the protrusions 32 are provided in the vapor chamber 100, and the protrusion 32 is located between adjacent grooves 31.

The "groove" in this embodiment of this application may be a groove provided on the inner surface of the cavity 13, or may be a trench formed between adjacent protrusions 32. The "protrusion" in this embodiment of this application may be a protrusion part that protrudes from the inner surface of the cavity 13, or may be a protrusion part formed between adjacent grooves. In this case, the protrusion may be even or not even with the inner surface of the cavity 13.

The groove 31 and/or the protrusion 32 are/is provided on the inner surface of the cavity 13, to increase an area of the inner surface of the cavity 13, thereby improving heat dissipation performance of the vapor chamber 100. Therefore, the heat dissipation structure 30 has an effect of enhancing heat dissipation. The heat dissipation structure 30 is disposed in an interior of the cavity 13, so that space of the cavity 13 can be used without increasing a thickness of the vapor chamber 100, and therefore the vapor chamber 100 can meet a design requirement of an ultra-thin electronic product.

Refer to both FIG. 1 and FIG. 2. A solid-line arrow in FIG. 2 indicates a flow direction of the cooling medium, and a dashed-line arrow indicates a flow direction of vapor. A working principle of the vapor chamber 100 provided in this embodiment of this application is as follows: The vapor chamber 100 is configured to be in contact with a heat source. The heat source may be a heating component 210. The heating component 210 is, for example, a system on chip (System on Chip, SoC), an integrated circuit chip (Integrated Circuit Chip, IC Chip), a power management unit (Power Management Unit, PMU), or a radio frequency integrated circuit (radio frequency integrated circuit, RFIC). A region in which the vapor chamber 100 is in contact with the heating component 210 is a heat source region. Heat generated by the heating component 210 can be transferred to the cavity 13. A cooling medium in the capillarity structure 20 near the heat source region rapidly absorbs heat and vaporizes into vapor, and the vapor serves as the gaseous cooling medium. The vapor is transferred to another end with lower pressure and condenses to release heat. The condensed and liquefied cooling medium then returns to the heat source region under a capillary action, to complete a heat transfer cycle.

The groove 31 or the protrusion 32 in the heat dissipation structure 30 may be disposed in a heat source region corresponding to the heating component 210, so that a heat exchange surface area of the heat source region can be increased, and temperature of the heat source can be quickly reduced. The groove 31 and the protrusion 32 may alternatively be disposed at one end far away from the heat source region, so that a heat exchange surface area of a corresponding region may also be increased, and the heat dissipation structure 30 plays a role in enhancing heat dissipation.

The vapor chamber 100 provided in this embodiment of this application includes the housing 10 having the cavity 13, and the capillarity structure 20 and the heat dissipation structure 30 that are disposed in the cavity 13. The heat dissipation structure 30 includes at least one structure of the protrusion 32 and the groove 31, to increase a surface area in the cavity 13, in other words, improve a heat exchange surface area, thereby improving the heat dissipation performance of the entire vapor chamber 100. The heat dissipation structure 30 is disposed in the interior of the cavity 13, so that the space of the cavity 13 can be used without increasing the thickness of the vapor chamber 100. Therefore, the heat dissipation performance of the vapor chamber 100 can be improved when the vapor chamber 100 meets an ultra-thin requirement for the electronic device.

Optionally, an edge of the first cover plate 11 and an edge of the second cover plate 12 are soldered by using a solder 50. The solder 50 may be a tin paste or the like.

Still refer to FIG. 2. The vapor chamber 100 includes an evaporation section 101 and a condensation section 102, the evaporation section 101 is a part of the vapor chamber 100 corresponding to the heating component 210, and the condensation section 102 is a part of the vapor chamber 100 other than the evaporation section 101; and the heat dissipation structure 30 is disposed in the evaporation section 101 and/or the condensation section 102.

The evaporation section 101 is a part that is of the vapor chamber 100 corresponding to the heating component 210 and that is along a thickness direction of the vapor chamber 100, in other words, a region where orthographic projection of the vapor chamber 100 on a first reference plane overlaps orthographic projection of the heating component 210 on the first reference plane. The first reference plane is a plane that is perpendicular to the thickness direction (which is also a direction in which the heating component 210 points toward the vapor chamber 100) of the vapor chamber 100. The condensation section 102 is the part of the vapor chamber 100 other than the evaporation section 101.

Heat generated by the heating component 210 is transferred to the evaporation section 101 of the vapor chamber 100. When the evaporation section 101 is heated, a cooling medium in this region evaporates and vaporizes, absorbs heat, and rapidly expands in volume. The gaseous cooling medium is quickly transferred from the evaporation section 101 (high-pressure region) to the condensation section 102 (low-pressure region). Because temperature of the condensation section 102 is low, the gaseous heat dissipation cooling medium condenses into liquid after releasing heat in the condensation section 102, and the liquid then returns to the evaporation section 101 by using capillary force generated by the capillarity structure 20, to complete a heat conduction cycle.

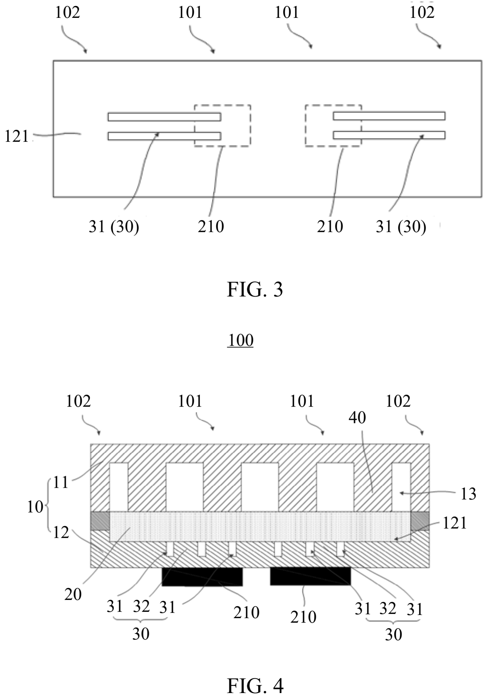

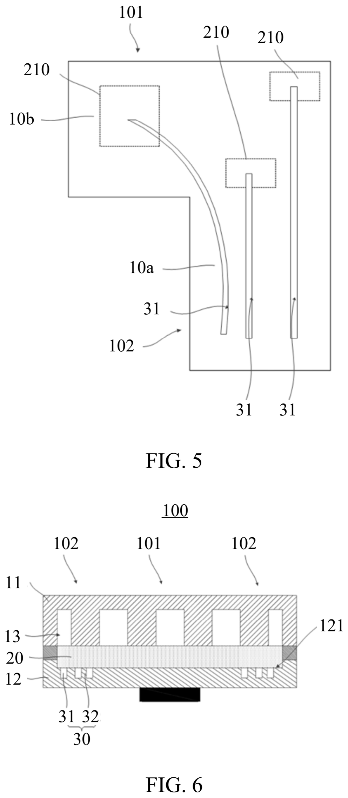

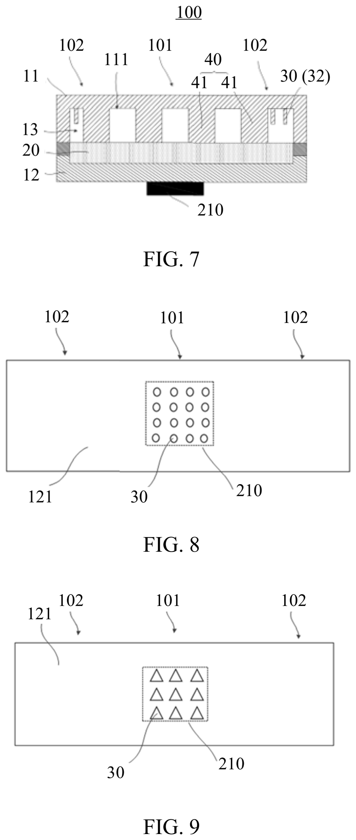

As shown in FIG. 2, in some embodiments, the heat dissipation structure 30 is disposed in the evaporation section 101, to improve a heat dissipation surface area of the evaporation section 101. In some other implementations, as shown in FIG. 3, the heat dissipation structure 30 may alternatively extend from the evaporation section 101 to the condensation section 102. In other words, the heat dissipation structure 30 is disposed in both the evaporation section 101 and the condensation section 102. Refer to FIG. 6 and FIG. 7. In some other embodiments, the heat dissipation structure 30 may alternatively be disposed only in the condensation section 102.

In this embodiment of this application, based on a location of the heat source, the vapor chamber 100 is divided into the evaporation section 101 and the condensation section 102, and the heat dissipation structure 30 may be disposed in the evaporation section 101 and/or the condensation section 102, to improve overall performance of the vapor chamber 100.

In some embodiments, the second cover plate 12 is closer to the heating component 210 than the first cover plate 11, and the inner surface of the cavity 13 includes a first surface 111 of the first cover plate 11 facing toward the cavity 13 and a second surface 121 of the second cover plate 12 facing toward the cavity 13; and the heat dissipation structure 30 is disposed on at least one of the first surface 111 and the second surface 121.

Specifically, the heat dissipation structure 30 may be disposed in the evaporation section 101 and/or the condensation section 102. If the heat dissipation structure 30 is disposed in the evaporation section 101, the heat dissipation structure 30 may be disposed in a region where the first surface 111 is located in the evaporation section 101, and/or a region where the second surface 121 is located in the evaporation section 101. If the heat dissipation structure 30 is disposed in the condensation section 102, the heat dissipation structure 30 may be disposed in a region where the first surface 111 is located in the condensation section 102, and/or a region where the second surface 121 is located in the condensation section 102.

The heat dissipation structure 30 may be disposed on the first surface 111 and/or the second surface 121, so that the heat exchange surface area of the vapor chamber 100 can be increased, and a manufacturing process is simple.

In some embodiments, the heat dissipation structure 30 is disposed on the second surface 121 and at least disposed in the evaporation section 101.

As shown in FIG. 1 and FIG. 2, the heat dissipation structure 30 is disposed on the second surface 121 and is entirely located in the evaporation section 101. The second cover plate 12 is configured to be close to the heating component 210, and projection of the heating component 210 on the second surface 121 is located in the evaporation section 101. Therefore, the heat dissipation structure 30 is disposed on the second surface 121 and located in the evaporation section 101, so that the heat dissipation surface area of the evaporation section 101 can be improved, thereby improving heat exchange efficiency between the heating component 210 and the vapor chamber 100, and improving heat dissipation efficiency.

FIG. 3 is a top view of a second cover plate in another vapor chamber 100 according to an embodiment of this application. As shown in FIG. 3, a heat dissipation structure 30 is disposed on a second surface 121, and the heat dissipation structure 30 extends from an evaporation section 101 to a condensation section 102. The heat dissipation structure 30 increases a heat exchange surface area. The heat dissipation structure 30 provides a capillarity channel for return of a cooling medium, to play a role of double capillarity, enhance capillarity force, and increase a return speed of the cooling medium from the condensation section 102 to the evaporation section 101.

In some embodiments, the heat dissipation structure 30 includes a groove, and the groove extends from the evaporation section 101 to the condensation section 102. It may be understood that, a protrusion is formed between adjacent grooves, and the protrusion is in a ribbing shape. In some other embodiments, the heat dissipation structure 30 includes a protrusion, the protrusion extends from the evaporation section 101 to the condensation section 102, a groove is formed between adjacent protrusions, and the groove is in a trench-like shape. It may be understood that, the heat dissipation structure 30 may also include both a groove and a protrusion, and a top of the groove and a top of the protrusion may be provided flush with each other or may have different heights.

FIG. 4 is a schematic diagram of a structure of another vapor chamber 100 according to an embodiment of this application. As shown in FIG. 4, a heat dissipation structure 30 is disposed on a second surface 121, and the heat dissipation structure 30 is disposed in an evaporation section 101. The vapor chamber 100 includes a plurality of evaporation sections 101, and each evaporation section 101 is disposed corresponding to one heating component 210. In this embodiment, the heat dissipation structure 30 includes grooves 31 and protrusions 32, and the protrusion 32 is formed between adjacent grooves 31.

As shown in FIG. 1 and FIG. 4, in some embodiments, the capillarity structure 20 is at least attached to the second surface 121. The heat dissipation structure 30 includes the grooves 31, and the groove 31 can accommodate a part of a cooling medium.

The capillarity structure 20 is for generating capillary force to transport the cooling medium. Because the heat dissipation structure 30 is also disposed on the second surface 121 and the heat dissipation structure 30 includes at least one groove 31, the groove 31 can accommodate a part of the cooling medium. The groove 31 increases a water accumulation capability, to play a role of double capillarity. When the heat dissipation structure 30 is disposed on the second surface 121 and is located in the evaporation section 101, the groove 31 can increase a water accumulation capability of the evaporation section 101, to effectively improve performance of the vapor chamber 100.

Refer to FIG. 3 again. In some embodiments, the groove 31 extends from the evaporation section 101 to the condensation section 102, and the groove 31 is configured to allow the cooling medium to flow from the condensation section 102 to the evaporation section 101.

An end of the groove 31 located in the evaporation section 101 may be located in any location of the evaporation section 101, such as in a middle or at an edge of the evaporation section 101. An end of the groove 31 located in the condensation section 102 may be located in any location of the condensation section 102, such as at an edge of the vapor chamber 100 or at an end of the condensation section 102 close to the evaporation section 101. A length of the groove 31 may be set based on requirements.

The groove 31 is provided below the capillarity structure 20, and the groove 31 can accommodate the cooling medium. The groove 31 extends from the evaporation section 101 to the condensation section 102. Therefore, the groove 31 may be used as a flow channel for the cooling medium to flow from the condensation section 102 to the evaporation section 101. The groove 31 is provided on the second surface 121, does not occupy vapor return space in a cavity 13, and does not affect return of vapor while increasing capillarity force. In some embodiments, a depth of the groove 31 is 40% to 60% of a thickness of a second cover plate 12. For example, the depth of the groove 31 is 40%, 50%, 55%, 60%, or the like of the thickness of the second cover plate 12. By setting the depth of the groove 31 to satisfy the foregoing condition, not only a surface area of the cavity 13 can be effectively increased, but also impact on structural stability of the second cover plate 12 caused by the groove 31 being excessively deep can be avoided.

In some embodiments, the depth of the groove 31 ranges from 10 micrometers to 1000 micrometers. For example, the depth of the groove 31 may be 10 micrometers, 50 micrometers, 100 micrometers, 400 micrometers, 500 micrometers, 600 micrometers, 800 micrometers, 1000 micrometers, or the like.

The depth of the groove 31 may be controlled based on a thickness of the vapor chamber 100. Optionally, the groove 31 is manufactured by etching, and the depth of the groove 31 is 10 micrometers or more. The thickness of the vapor chamber 100 is usually 2.6 mm or less, and the thickness of the second cover plate 12 is 2.3 mm or less. In this case, the depth of the groove 31 may be 1 mm, that is, 1000 micrometers.

Further, some vapor chambers 100 use an ultra-thin design. The thickness of the second cover plate 12 is 0.1 mm to 0.12 mm. In this case, the depth of the groove 31 ranges from 0.04 mm to 0.072 mm.

Refer to FIG. 1 and FIG. 4. In some embodiments, the capillarity structure 20 covers the heat dissipation structure 30, and there is a gap between a bottom of the groove 31 and the capillarity structure 20.

There being the gap between the bottom of the groove 31 and the capillarity structure 20 means that the capillarity structure 20 does not fill the groove 31 and is not in contact with the bottom of the groove 31.

The capillarity structure 20 and the groove 31 are both provided on the second surface 121. During manufacturing, the heat dissipation structure 30 is first manufactured on the second cover plate 12, and the heat dissipation structure 30 includes the groove 31. Then, the capillarity structure 20 is disposed on the second surface 121 of the second cover plate 12. The capillarity structure 20 does not fill the groove 31, but is spaced apart from the bottom of the groove 31. In this way, the groove 31 can independently accommodate the cooling medium and allow the cooling medium to flow, and play a role of double capillarity.

An outer shape of the vapor chamber 100 may be designed based on a layout of the heating component 210 and a structure of an electronic apparatus. A shape of the vapor chamber 100 may be a regular shape, for example, may be rectangular (as shown in FIG. 2), circular, or square, or certainly, may be an irregular shape, for example, may be an inverted "L" shape, or a "T" shape. Refer to FIG. 5. In some embodiments, a housing 10 includes a first part 10a and a second part 10b, the second part 10b is arranged at an angle relative to the first part 10a and is connected to first part 10a, the evaporation section 101 is disposed at the second part 10b, and the condensation section 102 is disposed at the first part 10a; and the groove 31 extends from the evaporation section 101 to the first part 10a, and the groove 31 extends in a straight line or an arc.

It should be noted that the "groove 31" in this embodiment may be a groove provided on the second surface 121, or may be a groove formed between adjacent protrusions.

FIG. 5 is used as an example. The first part 10a is arranged at an angle relative to the second part 10b. For example, the first part 10a is perpendicularly connected to the second part 10b and the second part 10b protrudes from one side of the first part 10a along a width direction of the second part 10b, making the housing 10 roughly in an inverted "L" shape. The vapor chamber 100 includes three evaporation sections 101, and the three evaporation sections 101 are all disposed in the second part 10b. A groove 31 corresponding to one evaporation section 101 extends in an arc to the first part 10a, while grooves 31 corresponding to the other two evaporation sections 101 extend in a straight line to the first part 10a. In this way, a shape of the groove 31 can be adapted to an arrangement manner of the evaporation section 101 and the condensation section 102, so that the cooling medium flows in the groove 31 to return to the evaporation section 101.

Refer to FIG. 3 to FIG. 5. In some embodiments, the vapor chamber 100 is provided with a plurality of evaporation sections 101, and one or more of the plurality of evaporation sections 101 is provided with the heat dissipation structure 30.

In the vapor chamber 100, the evaporation section 101 is disposed opposite to a heat source, and the condensation section 102 corresponding to the evaporation section 101 is located at the other end of the vapor chamber 100. As shown in FIG. 3 to FIG. 5, the vapor chamber 100 is provided with the plurality of evaporation sections 101, and heat dissipation structures 30 in the plurality of evaporation sections 101 are disposed at intervals. It may be understood that in another embodiment, if the plurality of evaporation sections 101 are adjacent to each other and are relatively close to each other, the heat dissipation structures 30 in the plurality of evaporation sections 101 may also be disposed adjacent to each other and disposed at a small interval. In addition, shapes and sizes of the heat dissipation structures 30 in all the evaporation sections 101 may be the same, or may be different.

One or more of the plurality of evaporation sections 101 is provided with the heat dissipation structure 30, so that each heat dissipation structure 30 may be used to separately enhance heat dissipation for a corresponding heating component 210.

The heat dissipation structure 30 may alternatively be disposed in the condensation section 102. Refer to FIG. 6. In some embodiments, the heat dissipation structure 30 is disposed on the second surface 121 and the heat dissipation structure 30 is located in the condensation section 102.

The heat dissipation structure 30 may include at least one structure of the groove 31 and the protrusion 32. In this embodiment, the heat dissipation structure 30 includes a plurality of grooves 31, the protrusion 32 is formed between adjacent grooves 31, and the protrusion 32 is flush with the remaining part of the second surface 121. It may be understood that the protrusion 32 may alternatively protrude from the remaining part of the second surface 121.

The heat dissipation structure 30 is disposed on the second surface 121 and located in the condensation section 102, so that the heat dissipation structure 30 can improve a heat exchange surface area of the condensation section 102, thereby improving overall performance of the vapor chamber 100.

Further, the capillarity structure 20 is disposed on the second surface 121, the capillarity structure 20 covers the heat dissipation structure 30, and the groove 31 in the heat dissipation structure 30 can accommodate the cooling medium.

Refer to FIG. 7. In some embodiments, the heat dissipation structure 30 is disposed on the first surface 111 and the heat dissipation structure 30 is located in the condensation section 102.

The heat dissipation structure 30 may include at least one structure of the groove 31 and the protrusion 32. In this embodiment, the heat dissipation structure 30 includes the protrusion 32, and the protrusion 32 is provided on the first surface 111. In another embodiment, the heat dissipation structure 30 may also include a groove (not shown) provided on the first surface 111.

The heat dissipation structure 30 is disposed on the first surface 111 and located in the condensation section 102, so that the heat dissipation structure 30 can improve a heat exchange surface area of the condensation section 102, thereby improving overall performance of the vapor chamber 100.

In some other embodiments, the heat dissipation structure 30 is disposed on the first surface 111 and located in the evaporation section 101. In some still other embodiments, the heat dissipation structure 30 may alternatively extend from the evaporation section 101 to the condensation section 102. For example, the heat dissipation structure 30 includes the protrusion 32, a vapor channel is formed between adjacent protrusions 32, and vapor may return from the evaporation section 101 to the condensation section 102 along the vapor channel.

Still refer to FIG. 7. The vapor chamber 100 further includes a support structure 40, and the support structure 40 extends from an inner surface of the cavity 13 to an interior of the cavity 13.

In this embodiment, the support structure 40 extends from the first surface 111 to the interior of the cavity 13. The support structure 40 can support an inner surface of the housing 10, to maintain space in the cavity 13, so that the cooling medium and the vapor can flow in the cavity 13.

The support structure 40 is disposed in the vapor chamber 100, and the support structure 40 can maintain the space in the cavity 13, so that the cooling medium and the vapor can flow in the cavity 13. The support structure 40 is disposed between the first cover plate 11 and the second cover plate 12, and can further improve a deformation resistance capability of the entire vapor chamber 100.

In some embodiments, the support structure 40 and the housing 10 are of an integrated structure, and the support structure 40 includes a plurality of columns 41 or bumps arranged in an array.

The support structure 40 and the housing 10 are of an integrated structure, and a manufacturing process is simple. For example, if the support structure 40 is disposed on the first surface 111, the support structure 40 and the first cover plate 11 are of an integrated structure.

The support structure 40 includes the plurality of columns 41 or bumps arranged in an array. For example, in this embodiment, the support structure 40 includes a plurality of columns 41 disposed on the first surface 111, and the columns 41 abut against the capillarity structure 20 on the second surface 121. It may be understood that in another embodiment, the support structure 40 may also include a plurality of bumps.

Because the plurality of columns 41 are arranged in an array, gaps between the plurality of columns 41 form vapor channels in the cavity 13, to allow vapor to flow in the cavity 13.

As shown in FIG. 7, in some embodiments, the support structure 40 and the heat dissipation structure 30 are both disposed on the first surface 111, and a height of the heat dissipation structure 30 on the first surface 111 is less than or equal to a height of the support structure 40.

The support structure 40, the heat dissipation structure 30, and the first cover plate 11 are of an integrated structure. Both the support structure 40 and the heat dissipation structure 30 may be simultaneously manufactured on the first surface 111 by etching, so that high manufacturing efficiency and low costs are achieved for the vapor chamber 100.

In another embodiment, the heat dissipation structure 30 and the first cover plate 11 are of an integrated structure, and the support structure 40 may be manufactured and fixed on the first surface 111 in another manner.

In this embodiment, the heat dissipation structure 30 includes a plurality of protrusions 32 provided on the condensation section 102, and a height of the protrusion 32 on the first surface 111 is less than or equal to a height of the support structure 40. In this way, the protrusion 32 does not affect assembly of the first cover plate 11 and the second cover plate 12.

Refer to FIG. 1, FIG. 4, and FIG. 6. In some embodiments, the heat dissipation structure 30 includes a plurality of protrusions 32 and a plurality of grooves 31, and the protrusion 32 is formed between adjacent grooves 31.

An example in which the heat dissipation structure 30 is disposed on the second surface 121 is used. During manufacturing, the second surface 121 is etched to form a plurality of grooves 31 arranged at intervals on the second surface 121. When the groove 31 is manufactured, a protrusion 32 is formed in a part of the second surface 121 that is located between adjacent grooves 31. The protrusion 32 protrudes relative to a bottom of the groove 31, and the protrusion 32 is flush with the remaining part of the second surface 121. Optionally, the protrusion 32 may alternatively be not flush with the remaining part of the second surface 121. For example, the protrusion 32 protrudes from the remaining part of the second surface 121.

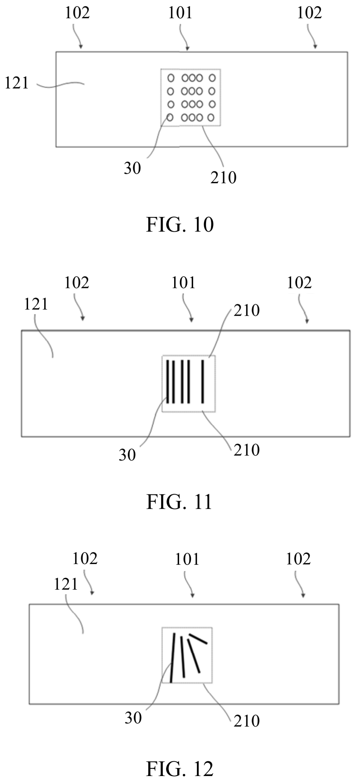

Refer to FIG. 1 to FIG. 12. The heat dissipation structure 30 includes the protrusion 32, and the protrusion 32 may be a convex column or a convex prim. The heat dissipation structure 30 marked in FIG. 8 to FIG. 12 may be a protrusion or a groove. As shown in FIG. 8 to FIG. 10, the protrusion is a convex column, and a shape of a cross section of the convex column includes at least one of a semi-circle, a circle, an ellipse, a triangle, a rectangle, a trapezoid, a pentagon, and a hexagon. As shown in FIG. 11 and FIG. 12, the groove is strip-shaped, and the protrusion is a convex prim.

Refer to FIG. 1 and FIG. 8. Optionally, the heat dissipation structure 30 includes a plurality of grooves 31, and sizes of the plurality of grooves 31 are the same or sizes of at least two grooves 31 are different; and/or the heat dissipation structure 30 includes a plurality of protrusions 32, and sizes of the plurality of protrusions 32 are the same or sizes of at least two protrusions 32 are different.

When the heat dissipation structure 30 includes a plurality of grooves 31, sizes of the plurality of grooves 31 are the same, and a manufacturing manner is convenient. In some other embodiments, sizes of at least two grooves 31 are different. For example, the size of the groove 31 gradually decreases from a middle of the evaporation section 101 to an edge of the evaporation section 101. For another example, sizes of two evaporation sections 101 are different, and sizes of grooves 31 in the two evaporation sections 101 are also different.

The "size" of the groove 31 includes a size of the groove 31 along a length direction of the vapor chamber 100, a size of the groove 31 along a width direction of the vapor chamber 100, and a size of the groove 31 along a thickness direction of the vapor chamber 100.

When the heat dissipation structure 30 includes a plurality of protrusions 32, sizes of the plurality of protrusions 32 are the same or sizes of at least two protrusions 32 are different.

The sizes of the plurality of grooves 31 or protrusions 32 are set to be the same or different, so that requirements of different electronic devices can be met.

Refer to FIG. 8 and FIG. 9. In some embodiments, the plurality of grooves are arranged at equal intervals; and/or the plurality of protrusions are arranged at equal intervals.

For example, in an evaporation section 101 or a condensation section 102, the plurality of grooves are arranged in an array, or the plurality of protrusions are arranged in an array. A plurality of heat dissipation structures 30 are arranged at equal intervals, so that the heat dissipation structures 30 can be evenly distributed in the evaporation section 101 or the condensation section 102, and therefore a heat dissipation surface area of the evaporation section 101 or the condensation section 102 is evenly increased.

The heat dissipation structure 30 is not limited thereto, and the plurality of grooves or protrusions may alternatively be arranged at uneven intervals. In some embodiments, refer to FIG. 10. Spacings between adjacent grooves decrease along a direction from the middle of the evaporation section 101 toward the condensation section 102. In this way, density of grooves in the middle of the evaporation section 101 is greater than the density of grooves at edges of the evaporation section 101, further enhancing a heat dissipation effect in the middle of the evaporation section 101.

Refer to FIG. 11. In some embodiments, the plurality of grooves are arranged parallel to each other; and/or the plurality of protrusions are arranged parallel to each other.

The heat dissipation structure 30 marked in FIG. 11 and FIG. 12 may be a groove or a protrusion. FIG. 11 is used as an example. When the heat dissipation structure 30 includes a plurality of grooves, the plurality of grooves are arranged parallel to each other, facilitating flow of the cooling medium in the grooves. Further, a shape of the evaporation section 101 and a shape of the heating component 210 are both rectangular, the grooves are strip-shaped, and all the grooves are parallel to edges of the evaporation section 101 and the heating component 210.

When the heat dissipation structure 30 includes a plurality of protrusions, the plurality of protrusions are arranged in parallel, also facilitating the flow of the cooling medium in a gap between adjacent protrusions 32.

Refer to FIG. 12. In another embodiment, the plurality of grooves or the plurality of protrusions may alternatively be arranged non-parallel to each other. For example, the plurality of grooves arranged in a diverging pattern to guide the cooling medium in a divergent manner toward the condensation section 102.

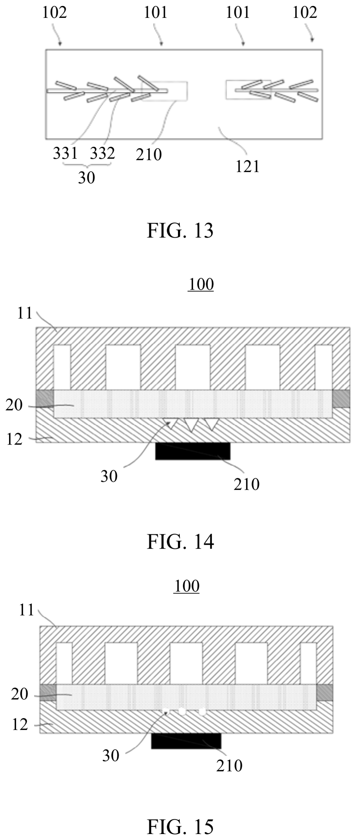

Refer to FIG. 13. In some embodiments, the heat dissipation structure 30 includes strip-shaped first heat dissipation parts 331 and a plurality of second heat dissipation parts 332 connected to the first heat dissipation parts 331, the plurality of second heat dissipation parts 332 are sequentially arranged on two sides of the first heat dissipation part 331 along an extension direction of the first heat dissipation part 331, and the first heat dissipation part 331 and the second heat dissipation part 332 are the protrusions or the grooves.

Specifically, the heat dissipation structure 30 is disposed on the second surface 121. In this embodiment, an example in which the first heat dissipation part 331 and the second heat dissipation part 332 are the grooves is used for description. In this case, both the first heat dissipation part 331 and the second heat dissipation part 332 can accommodate the cooling medium and allow the cooling medium to flow.

The heat dissipation structure 30 includes the strip-shaped first heat dissipation part 331, one end of the first heat dissipation part 331 is located in the evaporation section 101, and the other end extends to the condensation section 102. A plurality of second heat dissipation parts 332 are disposed in the evaporation section 101 and the remaining second heat dissipation parts 332 are disposed in the condensation section 102. Therefore, the heat dissipation structure 30 is in a shape of a leaf vein as a whole, not only increasing a heat dissipation surface area of the cavity 13, but also further increasing capillarity force.

Optionally, the second heat dissipation parts 332 are obliquely connected to the first heat dissipation part 331. The second heat dissipation parts 332 extend along both a length direction and a width direction of the vapor chamber 100, to improve a heat dissipation area and a heat dissipation effect

It may be understood that the second heat dissipation parts 332 may alternatively be perpendicularly connected to the first heat dissipation part 331.

In some embodiments, a shape of a cross section of the heat dissipation structure 30 includes at least one of a semi-circle, a circle, an ellipse, a triangle, a rectangle, a trapezoid, a pentagon, and a hexagon. A cross section of the heat dissipation structure 30 is parallel to a thickness direction of the vapor chamber 100.

The heat dissipation structure 30 may include at least one structure of the groove 31 and the protrusion 32. Specifically, a shape of a cross section of the groove 31 and/or a shape of a cross section of the protrusion 32 may include at least one of a semi-circle, a circle, an ellipse, a triangle, a rectangle, a trapezoid, a pentagon, and a hexagon.

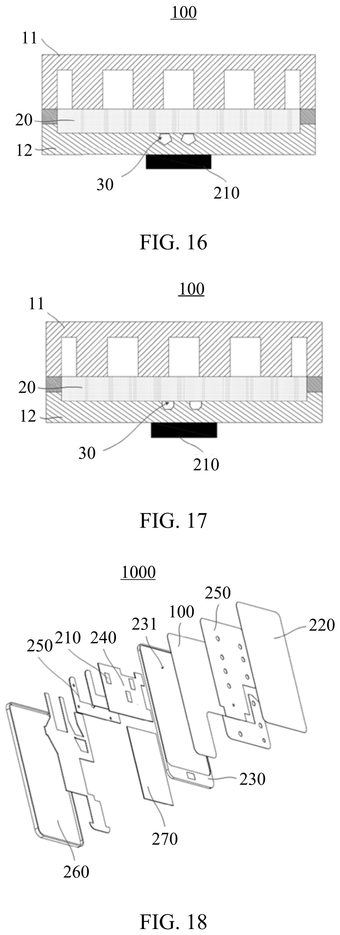

Refer to FIG. 14, the shape of the cross section of the heat dissipation structure 30 is a triangle. Refer to FIG. 15, the shape of the cross section of the heat dissipation structure 30 is a semi-circle. Refer to FIG. 16, the shape of the cross section of the heat dissipation structure 30 is a pentagon. Refer to FIG. 17, the shape of the cross section of the heat dissipation structure 30 is a hexagon. It may be understood that in another embodiment, the shape of the cross section of the heat dissipation structure 30 may alternatively be a combined shape. For example, the shape of the heat dissipation structure 30 includes a combination of semi-circle and square.

A shape of the heat dissipation structure 30 may be selected based on an actual use requirement, and a manufacturing manner is flexible and convenient.

In some embodiments, the capillarity structure 20 is a cellular medium using a metal as a base.

In some embodiments, the capillarity structure 20 is one or more of copper mesh, copper fiber, copper powder, or foam copper.

Refer to FIG. 18. An embodiment of a second aspect of this application provides an electronic device 1000, including the vapor chamber 100 provided in the first aspect.

The electronic device 1000 may include, but is not limited to, a mobile or stationary terminal with a battery, such as a mobile phone, a tablet computer, a laptop computer, an ultra-mobile personal computer (ultra-mobile personal computer, UMPC), a handheld computer, a walkie-talkie, a netbook, a POS machine, a personal digital assistant (personal digital assistant, PDA), a wearable device, or a virtual reality device.

The electronic device 1000 includes the vapor chamber 100, and has a good heat dissipation effect and stable performance. Restricted by a requirement of an ultra-thin architecture of the electronic device 1000, there is a conflict between an ultra-thin design and a high-performance requirement of the vapor chamber 100. In this embodiment of this application, an internal design of the vapor chamber is optimized, to effectively improve performance of the vapor chamber 100.

In some embodiments, the electronic device 1000 further includes a circuit board 240, a middle frame 230, and a display screen 220, the middle frame 230 is provided with a mounting hole, the vapor chamber 100 is at least partially embedded in the mounting hole 231, and the vapor chamber 100 and the middle frame 230 both carry the display screen 220; and the circuit board 240 is disposed on a side of the middle frame 230 facing away from the display screen and a heating component 210 is disposed on the circuit board 240.

The mounting hole 231 may be a blind hole, but this is not limited thereto. The mounting hole 231 may alternatively be a through hole. A shape and a size of the mounting hole 231 may be adapted to the vapor chamber 100, but this is not limited thereto. A size of the mounting hole 231 may alternatively be greater than that of the vapor chamber 100.

The circuit board 240 and the vapor chamber 100 are respectively disposed on opposite sides of the middle frame 230, and the vapor chamber 100 can dissipate heat from the heating component 210 on the circuit board 240. The vapor chamber 100 is at least partially embedded in the mounting hole 231, facilitating achievement of a thinner electronic device 1000.

In some embodiments, the electronic device 1000 includes at least three heating components 210, the vapor chamber 100 includes three evaporation sections 101, and the three evaporation sections 101 are respectively disposed corresponding to the three heating components 210.

Optionally, one of the heating components 210 is a main heat source, and the main heat source is, for example, a system on chip (System on Chip, SoC), a central processing unit (central processing unit, CPU), or a power management unit (Power Management Unit, PMU). The remaining heating components 210 may be fast charging chips, power amplifiers (Power Amplifiers, PAs), or the like. For example, the main heat source of the electronic device 1000 is the PMU, and remaining heat sources include one or more fast charging chips.

Optionally, a heat dissipation structure 30 corresponding to the main heat source is arc-shaped and extends from an evaporation section 101 to a condensation section 102, to facilitate flow of a cooling medium in the heat dissipation structure 30.

It may be understood that, one evaporation section 101 also corresponds to a plurality of adjacent heating components 210. In other words, evaporation sections 101 corresponding to a plurality of heating components 210 are integrated and arranged as a whole.

It can be understood that quantities of heating components 210 and evaporation sections 101 are not limited thereto. For example, there is one heating component 210 and one evaporation section 101.

In some embodiments, the electronic device 1000 further includes a heat dissipation film 250, and the heat dissipation film 250 is disposed on a side of the vapor chamber 100 facing away from the circuit board 240, and/or a side of the circuit board 240 facing away from the vapor chamber 100.

When the heat dissipation film 250 is disposed on the side of the vapor chamber 100 facing away from the circuit board 240, the heat dissipation film 250 is located between the vapor chamber 100 and the display screen, and heat generated by the heating component 210 on the circuit board 240 is first transferred to the vapor chamber 100, and then is transferred to the heat dissipation film 250 through the vapor chamber 100 to dissipate heat.

When the heat dissipation film 250 is disposed on the side of the circuit board 240 facing away from the vapor chamber 100, some of heat generated by the heating component 210 on the circuit board 240 may be transferred to the heat dissipation film 250, to dissipate heat through the heat dissipation film 250.

Optionally, as shown in FIG. 18, the electronic device 1000 includes a plurality of heat dissipation films 250. A side of the vapor chamber 100 facing away from the circuit board 240 and a side of the circuit board 240 facing away from the vapor chamber 100 are both provided with heat dissipation films 250, further improving a heat dissipation effect of the electronic device 1000.

Optionally, the heat dissipation film 250 is a graphitic heat dissipation film, and has good heat conduction performance, so that the graphitic heat dissipation film can rapidly dissipate heat.

The heat dissipation film 250 is disposed, so that the electronic device 1000 uses both the vapor chamber 100 and the heat dissipation film 250 to dissipate heat of the heating component 210, thereby further improving the heat dissipation effect and performance stability.

The electronic device 1000 further includes a rear housing 260 and a battery 270. The rear housing 260 is connected to a side of the middle frame 230 facing away from the display screen 220, and the battery 270 is disposed between the rear housing and the middle frame 230.

Finally, it should be noted that, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A vapor chamber, comprising:
a housing, wherein the housing comprises a first cover plate and a second cover plate, the first cover plate is connected to the second cover plate to enclose a closed cavity, and the cavity is provided with a cooling medium;
a capillarity structure, disposed in the cavity; and
a heat dissipation structure, disposed in an inner surface of the cavity, wherein the heat dissipation structure comprises at least one structure of a protrusion and a groove.

2. The vapor chamber according to claim 1, wherein the vapor chamber comprises an evaporation section and a condensation section, the evaporation section is a part of the vapor chamber corresponding to a heating component, and the condensation section is a part of the vapor chamber other than the evaporation section; and
the heat dissipation structure is disposed in the evaporation section and/or the condensation section.

3. The vapor chamber according to claim 2, wherein the second cover plate is closer to the heating component than the first cover plate, and the inner surface of the cavity comprises a first surface of the first cover plate facing toward the cavity and a second surface of the second cover plate facing toward the cavity; and
the heat dissipation structure is disposed on at least one of the first surface and the second surface.

4. The vapor chamber according to claim 3, wherein the heat dissipation structure is disposed on the second surface and at least disposed in the evaporation section.

5. The vapor chamber according to claim 4, wherein the capillarity structure is at least attached to the second surface.

6. The vapor chamber according to claim 5, wherein the heat dissipation structure comprises the groove, and the groove can accommodate a part of the cooling medium.

7. The vapor chamber according to claim 6, wherein the groove extends from the evaporation section to the condensation section, and the groove is for allowing the cooling medium to flow from the condensation section to the evaporation section.

8. The vapor chamber according to claim 6, wherein a depth of the groove is 40% to 60% of a thickness of the second cover plate.

9. The vapor chamber according to claim 6, wherein a depth of the groove ranges from 10 micrometers to 1000 micrometers.

10. The vapor chamber according to claim 6, wherein the capillarity structure covers the heat dissipation structure, and there is a gap between a bottom of the groove and the capillarity structure.

11. The vapor chamber according to claim 6, wherein the housing comprises a first part and a second part, the second part is arranged at an angle relative to the first part and is connected to the first part, the evaporation section is disposed at the second part, and the condensation section is disposed at the first part; and
the groove extends from the evaporation section to the first part, and the groove extends in a straight line or an arc.

12. The vapor chamber according to claim 4, wherein the vapor chamber is provided with a plurality of evaporation sections, and one or more of the plurality of evaporation sections is provided with the heat dissipation structure.

13. The vapor chamber according to claim 3, wherein the heat dissipation structure is disposed on the second surface and the heat dissipation structure is located in the condensation section.

14. The vapor chamber according to claim 3, wherein the heat dissipation structure is disposed on the first surface and the heat dissipation structure is located in the condensation section.

15. The vapor chamber according to claim 3, wherein the vapor chamber further comprises a support structure, and the support structure extends from the inner surface of the cavity to an interior of the cavity.

16. The vapor chamber according to claim 15, wherein the support structure comprises a plurality of columns or bumps arranged in an array.

17. The vapor chamber according to claim 16, wherein the support structure and the heat dissipation structure are both disposed on the first surface, and a height of the heat dissipation structure on the first surface is less than or equal to a height of the support structure.

18. The vapor chamber according to claim 17, wherein the heat dissipation structure, the support structure, and the first cover plate are of an integrated structure.

19. The vapor chamber according to any one of claims 1 to 18, wherein the heat dissipation structure comprises the protrusion, and the protrusion is a convex column or a convex prim.

20. The vapor chamber according to any one of claims 1 to 18, wherein the heat dissipation structure comprises a plurality of grooves, and sizes of the plurality of grooves are the same or sizes of at least two grooves are different; and/or
the heat dissipation structure comprises a plurality of protrusions, and sizes of the plurality of protrusions are the same or sizes of at least two protrusions are different.

21. The vapor chamber according to claim 20, wherein the plurality of grooves are arranged at equal intervals; and/or
the plurality of protrusions are arranged at equal intervals.

22. The vapor chamber according to claim 20, wherein the plurality of grooves are arranged parallel to each other; and/or
the plurality of protrusions are arranged parallel to each other.

23. The vapor chamber according to any one of claims 1 to 18, wherein a shape of a cross section of the protrusion or the groove comprises at least one of a semi-circle, a circle, an ellipse, a triangle, a rectangle, a trapezoid, a pentagon, and a hexagon.

24. The vapor chamber according to any one of claims 1 to 12, wherein the heat dissipation structure comprises a strip-shaped first heat dissipation part and a plurality of second heat dissipation parts connected to the first heat dissipation part, the plurality of second heat dissipation parts are sequentially arranged on two sides of the first heat dissipation part along an extension direction of the first heat dissipation part, and the first heat dissipation part and the second heat dissipation part are the protrusions or the grooves.

25. The vapor chamber according to claim 24, wherein the second heat dissipation parts are obliquely connected to the first heat dissipation part.

26. The vapor chamber according to any one of claims 1 to 18, wherein the capillarity structure is a cellular medium made of a metal material.

27. The vapor chamber according to claim 26, wherein the capillarity structure is one or more of copper mesh, copper fiber, copper particles, or foam copper.

28. An electronic device, comprising: the vapor chamber according to any one of claims 1 to 27.

29. The electronic device according to claim 28, wherein the electronic device further comprises a circuit board, a middle frame, and a display screen, the middle frame is provided with a mounting hole, the vapor chamber is at least partially embedded in the mounting hole, and the vapor chamber and the middle frame both carry the display screen; and the circuit board is disposed on a side of the middle frame facing away from the display screen and a heating component is disposed on the circuit board.

30. The electronic device according to claim 29, wherein the electronic device further comprises a heat dissipation film, and the heat dissipation film is disposed on a side of the vapor chamber facing away from the circuit board, and/or a side of the circuit board facing away from the vapor chamber.
